# FASCICULE DE BREVET EUROPEEN

(11) **EP 2 511 712 B1**
(45) Date de publication et mention de la délivrance du brevet: **05.09.2018**
(21) Numéro de dépôt: 12354020.5
(22) Date de dépôt: 07.03.2012
(51) Int. Cl.: G01R 15/18

(54) **Dispositif de mesure d'un courant électrique comprenant un tore de Rogowski**
Vorrichtung zum Messen von elektrischem Strom umfassend eine Rogowskispule
Device for measuring electric current comprising a Rogowski coil

(30) Priorité: 11.04.2011 FR 1101104
(43) Date de publication de la demande: 17.10.2012
(73) Titulaire: Schneider Electric Industries SAS, 92500 Rueil-Malmaison (FR)
(72) Inventeur: Moreaux, Alain, 38050 Grenoble Cedex 09 (FR); Houbre, Pascal, 38050 Grenoble Cedex 09 (FR)
(74) Mandataire: Tripodi, Paul

(56) Documents cités:
- EP-A2- 0 218 225
- WO-A1-2009/139521
- DE-U1- 9 014 565
- FR-A1- 2 717 582
- JP-A- 11 295 349

## Description

### Domaine technique de l'invention

L'invention concerne le domaine de la mesure d'un courant électrique circulant dans un câble.

L'invention a pour objet plus particulièrement dispositif de mesure d'un courant électrique circulant dans un câble, comprenant des moyens de maintien d'un tore de Rogowski souple pouvant occuper une position ouverte permettant l'engagement autour du câble et une position fermée apte à entourer le câble.

Elle concerne également un ensemble de mesure de ce courant comprenant au moins un tel dispositif de mesure, ainsi qu'un dispositif de mesure de puissance et d'énergie comprenant au moins un tel capteur de mesure.

### État de la technique

Il existe de nombreux capteurs de mesure d'un courant électrique circulant dans un câble qui peuvent être montés autour du câble sans avoir à interrompre la distribution d'énergie électrique ni à intervenir sur l'installation électrique. De tels capteurs agissent en tant que transformateur d'intensité, utilisant le champ magnétique généré par la circulation du courant dans le câble. Plus précisément, le câble constitue en pratique le primaire du transformateur, bien qu'il ne soit pas équipé de bobinage primaire à proprement parler : la spire du primaire est constituée par le passage du câble dans lequel circule l'intensité à mesurer dans le secondaire du transformateur.

Le secondaire du transformateur quant à lui peut-être formé de plusieurs manières. Une première solution consiste à aménager un circuit magnétique fermé enfilé sur le câble et une bobine de plusieurs spires est bobinée autour du circuit magnétique. Le circuit magnétique peut être constitué en une seule partie mais il est alors nécessaire de débrancher le câble pour enfiler le secondaire du transformateur sur le câble qui doit ensuite être branché à nouveau. Ces tâches sont fastidieuses et peu sécuritaires.

Une autre construction, telle que décrite dans le document US-A-4048605, consiste à prévoir un circuit magnétique en deux parties rigides articulées pour s'écarter l'une de l'autre lors de la mise en place du câble à l'intérieur du circuit magnétique et pour se refermer ensuite l'une contre l'autre afin qu'en position de travail, le circuit magnétique soit bien fermé. Une telle disposition est couramment utilisée dans le domaine des pinces ampérométriques.

Toutefois les agencements de ce type présentent l'inconvénient majeur que l'ouverture du circuit magnétique en deux parties rigides nécessite des moyens mécaniques qui sont complexes et deux zones d'ouverture qui ont une sensibilité plus grande au champ magnétique d'origine externe ou interne et faussent ainsi la mesure du courant primaire. De plus, la rigidité et l'encombrement de l'ensemble interdisent certaines accessibilités aux mesures. Le poids de l'agencement constitue également un inconvénient pour les circuits magnétiques de plus grand diamètre, en fonction notamment du diamètre du câble.

Une deuxième solution pour constituer le secondaire du transformateur d'intensité formé par un composant de mesure formant partie du capteur de mesure consiste à utiliser un tore de Rogowski. De manière connue, celui-ci se compose d'un enroulement hélicoïdal de fil dont une extrémité revient par le centre de l'enroulement à l'autre extrémité, de sorte que les deux bornes sont situées à la même extrémité de l'enroulement. La bobine ainsi formée est positionnée autour du câble. La tension induite dans l'enroulement est par exemple proportionnelle au taux de changement (dérivée) du courant dans le câble. Le tore de Rogowski est habituellement relié à un circuit d'intégration électrique (ou électronique) à forte impédance d'entrée afin de fournir un signal de sortie qui est proportionnel au courant.

Le document US-B2-7253603 décrit une solution mettant en oeuvre un tore de Rogowski de type rigide. Le tore adopte constamment une forme non plane mais hélicoïdale dans la direction du câble, de sorte que les deux extrémités du tore ne coïncident pas et sont au contraire décalées pour délimiter un espace suffisant pour permettre l'engagement du câble dans ce tore hélicoïdal.

Les documents EP-A1-0999565 et US-A1-3343052 décrivent quant à eux des solutions pouvant utiliser un tore de Rogowski souple et ouvrant, susceptible de varier, par déformation du tore, entre une position fermée ceinturant le câble dans lequel circule le courant à mesurer et une position ouverte permettant l'engagement du câble à l'intérieur du tore. Le maintien du tore en position fermée est réalisé par un mécanisme de fermeture par exemple à encliquetage rapide tel qu'un emboîtement de type mâle/femelle. Toutefois la présence d'un tel mécanisme de fermeture oblige à une action manuelle directement sur le tore au niveau de ses extrémités libres pour verrouiller ou déverrouiller le mécanisme de fermeture afin de pouvoir déformer manuellement le tore, par manipulation manuelle d'au moins l'une des extrémités libres, entre ses positions fermée et ouverte. Ces actions manuelles sur le mécanisme de fermeture et les manipulations manuelles de ladite au moins une extrémité libre du tore sont délicates, fastidieuses, et peu pratiques à accomplir concrètement, notamment en cas d'accessibilité restreinte aux mesures.

D'autres dispositifs de mesure à tore de Rogowski sont décrits dans les documents FR2717582, JP11295349 et WO2009/139521.

### Objet de l'invention

Le but de la présente invention est de remédier à ces inconvénients, en proposant un dispositif de mesure d'un courant électrique circulant dans un câble qui facilite la réalisation de la mesure.

Un dispositif selon l'invention est défini dans les revendications.

Avantageusement, un ressort de rappel sollicite les mâchoires vers leur position rapprochée pour assurer une fermeture au moins partiellement automatique du tore.

De préférence, les mâchoires sont équipées d'éléments écarteurs configurés de sorte à transformer un effort appliqué par le câble sur lesdits éléments écarteurs, en direction de l'intérieur du tore lors de l'engagement du câble, en un mouvement d'écartement des mâchoires. De préférence, les éléments écarteurs comportent chacun une rampe inclinée par rapport à la direction attendue du mouvement d'engagement du câble vers l'intérieur du tore.

Dans un mode de réalisation particulier, le dispositif comprend un circuit magnétique se refermant autour du câble lorsque les moyens d'actionnement commandent la position fermée du tore, et un bobinage autour du circuit magnétique, pour alimenter une électronique de mesure et/ou de transmission du résultat des mesures.

De préférence, au moins l'une des mâchoires porte au moins une partie du circuit magnétique et du bobinage, ledit circuit magnétique étant fermé lorsque les moyens de maintien sont en position fermée.

Dans un mode de réalisation préférentiel, le dispositif comprend des moyens de centrage pour centrer les moyens de maintien et les ledit tore autour d'un câble électrique, lesdits moyens de centrage étant sous forme tiges flexibles.

De préférence, le bobinage est formé sur une structure permettant un bobinage linéaire.

De préférence, les mâchoires sont chacune montées à pivotement sur une armature pouvant être reliée à une tige de commande dont le mouvement de translation par rapport à l'armature commande le mouvement de pivotement de chacune des mâchoires par rapport à l'armature.

De préférence, lorsque le tore est en position fermée il a une zone non enroulée de distance prédéterminée et un surenroulement à chaque extrémité d'ouverture dudit tore.

Un ensemble de mesure selon l'invention comprend au moins un dispositif de mesure tel que défini ci-dessus. Avantageusement, l'ensemble comporte une électronique de mesure et/ou de transmission du résultat des mesures recevant des données du tore du dispositif de mesure.

L'invention porte également sur un capteur de mesure comprenant au moins un dispositif de mesure de ce type, ainsi qu'un dispositif de mesure de puissance et d'énergie comprenant au moins un capteur tel que ci-dessus.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en perspective avant d'un dispositif de mesure d'un premier mode de réalisation d'un capteur de mesure selon l'invention,
- la figure 2 est une vue en perspective avant d'un dispositif de mesure d'un deuxième mode de réalisation d'un capteur de mesure selon l'invention, le tore de Rogowski étant désolidarisé,
- la figure 3 illustre une vue en perspective arrière du dispositif de la figure 1,
- la figure 4 représente le dispositif de la figure 2 dans une configuration au moins partiellement ouverte du tore de Rogowski après manipulation d'une tige de commande,
- la figure 5 illustre un exemple de tige de commande,
- la figure 6 représente de face le dispositif de la figure 2 dans la une configuration commandant la position ouverte du tore,
- la figure 7 représente une vue en perspective d'une variante du dispositif de la figure 1 en position fermée du tore, préalablement à l'engagement d'un câble à l'intérieur du tore,
- la figure 8 est une vue en perspective d'une structure pour bobinage utilisée dans le deuxième mode de réalisation,
- la figure 9 illustre un agencement complet possible d'un capteur selon les premier et deuxième modes de réalisation,
- la figure 10 représente un montage possible de l'agencement de la figure 9 sur une installation électrique ayant plusieurs câbles dans lesquels circule un courant électrique,
- la figure 11 représente une position fermée des mâchoires,
- la figure 12 montre une vue détaillée de la zone d'ouverture du capteur dans sa position fermée.

### Description de modes préférentiels de l'invention

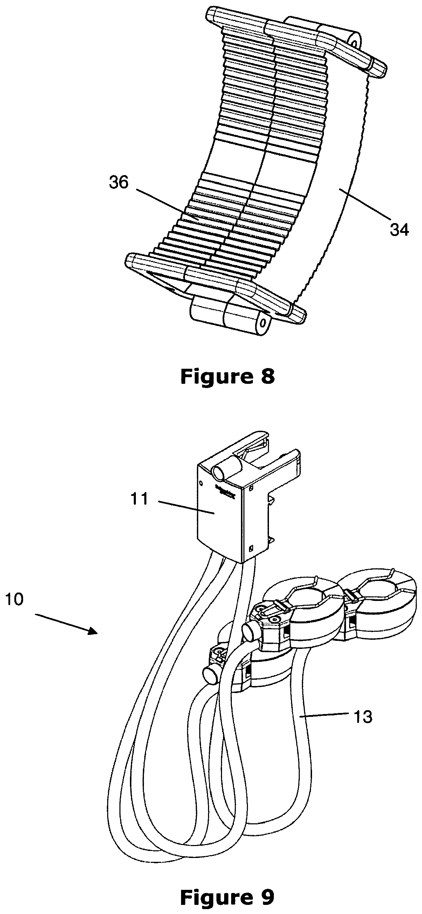

En référence à la figure 9, un agencement complet possible d'un capteur de mesure 10 selon l'invention comporte un boîtier 11 dans lequel est logée une électronique de mesure et/ou de transmission du résultat des mesures. L'électronique reçoit des données provenant d'au moins un dispositif de mesure 12 idoine (au nombre de trois dans l'exemple de la figure 9) par l'intermédiaire d'au moins une connexion 13, ces données étant en relation avec la valeur du courant électrique à mesurer.

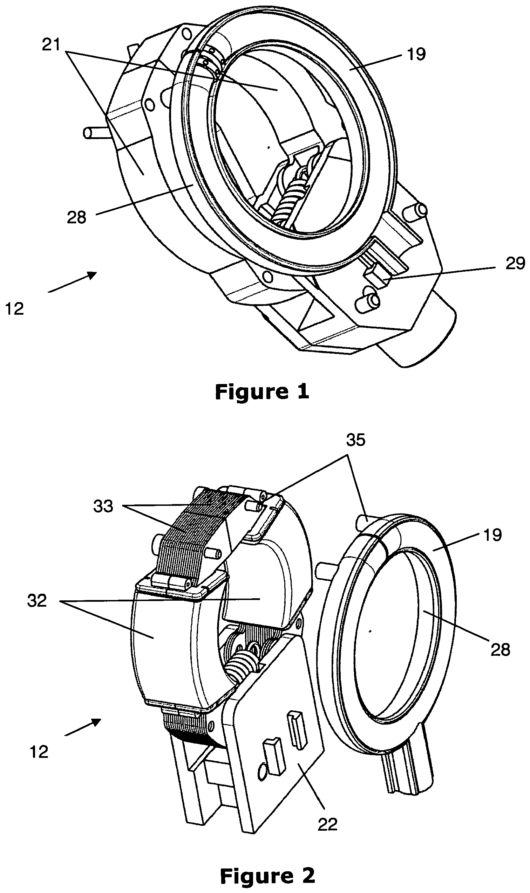

Les figures 1 et 2 illustrent un tel dispositif de mesure 12 utilisé dans l'agencement d'un capteur de mesure 10 respectivement selon des premier et deuxième modes de réalisation. Dans le deuxième mode de réalisation représenté sur la figure 2, le dispositif de mesure 12 assure l'alimentation électrique de l'électronique de mesure et/ou de transmission du résultat des mesures, ce qui n'est pas le cas du dispositif de mesure 12 selon le premier mode de réalisation représenté sur la figure 1. En effet, le dispositif de mesure 12 visible sur la figure 1 n'a pour unique vocation que de transmettre à cette électronique la seule donnée en relation avec la valeur du courant électrique à mesurer par le dispositif 12 concerné.

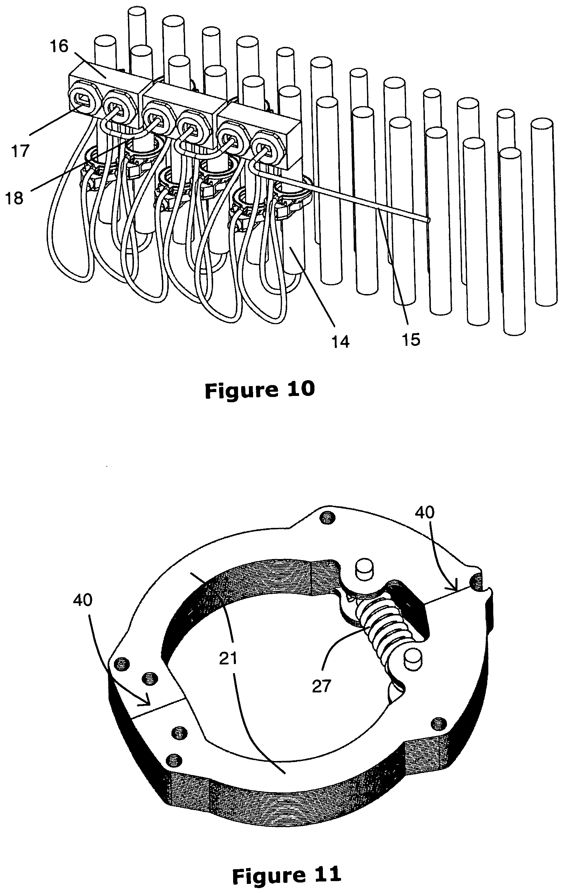

En référence à la figure 10, l'agencement de la figure 9 est destiné à être monté sur une installation électrique ayant plusieurs câbles 14 dans lesquels circule un courant électrique à mesurer. Sur la figure 10, trois capteurs de mesure 10 selon le premier mode de réalisation sont montés sur l'installation de sorte que chacun des trois dispositifs de mesure 12 des trois capteurs 10 soit associé à l'un des câbles 14 de l'installation afin de mesurer individuellement la valeur du courant électrique qui circule dans le câble 14 associé au dispositif de mesure 12 correspondant. Sur la figure 10, l'électronique de mesure et/ou de transmission du résultat des mesures de chacun des capteurs 10 reçoit une alimentation électrique extérieure par l'intermédiaire d'un bus principal de communication 15 raccordé à un boîtier de concentration de données 16 logeant chacun l'électronique du capteur 10 et pourvu d'au moins une prise de raccordement 17 du bus principal 15 ou de bus inter-capteurs 18 réalisant la communication et l'alimentation entre les capteurs 10. Dans le cas où les capteurs de mesure 10 utilisés sur la figure 10 correspondent au deuxième mode de réalisation, les éléments 15 à 18 peuvent avantageusement être supprimés.

Un dispositif de mesure 12 selon un aspect de l'invention destiné à réaliser la mesure d'un courant électrique circulant dans au moins un câble 14, comprend un tore de Rogowski 19 au niveau de chacun de ses dispositifs de mesure 12, comme l'illustrent les figures 1 et 2 notamment. Ainsi, le dispositif 12 comprend au moins un tore de Rogowski 19 souple pouvant occuper une position ouverte permettant l'engagement autour du câble 14 et une position fermée apte à ceinturer le câble 14. L'engagement du tore 19 autour du câble 14 correspond à la mise en place du dispositif de mesure 12 du capteur de mesure 10 et se traduit par un engagement du câble 14 à l'intérieur du tore 19. Celui-ci se compose d'un enroulement par exemple hélicoïdal de un ou plusieurs fil(s) bobiné(s) en une ou plusieurs couche(s) sur un tube souple et recourbé en forme générale de tore. Le bobinage de fil(s) est réalisé de sorte que les deux bornes du bobinage sont situées à l'une des deux extrémités libres du tore 19 qui est apte à s'ouvrir au niveau d'une discontinuité du tube formant les deux extrémités libres. Concrètement, les extrémités libres du tore 19 sont par exemple en contact dans la position fermée du tore 19 et sont écartées l'une de l'autre dans la position ouverte du tore 19 selon une distance suffisante pour laisser le câble 14 pénétrer à l'intérieur du tore 19. En position fermée, la bobine ainsi formée par l'enroulement de fil(s) est positionnée autour du câble 14. Il peut être prévu un sur-bobinage de spires à chaque extrémité libre du tore 19 pour compenser l'entrefer présent en position fermée. Cet entrefer est avantageusement maintenu constant en position fermée grâce aux moyens d'actionnement décrits ci-dessous.

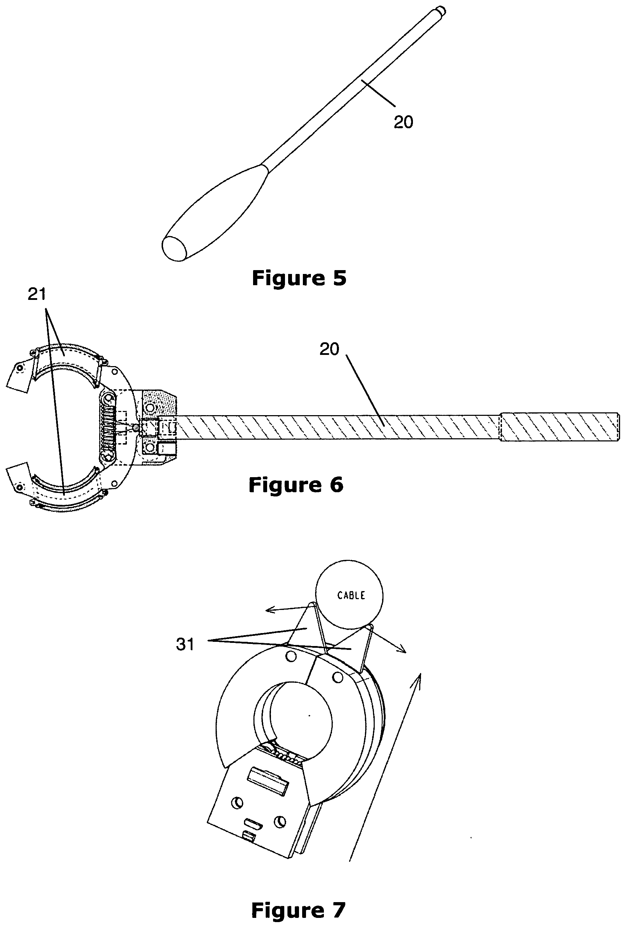

En effet selon un aspect essentiel, le dispositif de mesure 12 (qu'il soit selon le premier mode de réalisation de la figure 1 ou selon le deuxième mode de réalisation de la figure 2) comprend des moyens d'actionnement, par exemple de type mécaniques, configurés de sorte à être susceptibles de passer le tore 19 d'une position à l'autre sans que l'utilisateur du capteur 10 n'ait à venir saisir et manipuler le tore 19 avec ses mains. Au contraire, les moyens d'actionnement peuvent avantageusement être contrôlés à distance au moyen d'une tige de commande 20 par exemple, visible sur la figure 5.

Les moyens d'actionnement peuvent comprendre deux mâchoires 21 articulées, de forme incurvées, auxquelles le tore 19 est solidarisé et pouvant occuper soit une position écartée soit une position rapprochée plaçant le tore 19 respectivement dans ses positions ouverte et fermée. Les mâchoires 21 sont agencées dans un plan parallèle au plan du tore 19. Le plan de déplacement des mâchoires 21 quand elles varient entre les positions écartée et rapprochée est décalé par rapport au plan de déformation du tore 19 entre ses positions ouverte et fermée dans une direction perpendiculaire à ces plans. La courbure des mâchoires 21 est incluse de le plan de déplacement des mâchoires et configurée de sorte que les faces concaves des mâchoires 21 se font face dans ce plan. La figure 6 illustre le dispositif de mesure 12 de la figure 2 dans le cas où les mâchoires 21 adoptent leur position écartée. Une forme particulière par exemple ovoïdale des mâchoires 21 peut être optimisée afin de pouvoir maximiser la distance séparant les extrémités libres de mâchoires 21 en position écartée tout en réduisant l'encombrement général des mâchoires 21. Dans la position rapprochée des mâchoires 21, les extrémités libres de celles-ci viennent par exemple en contact l'une de l'autre.

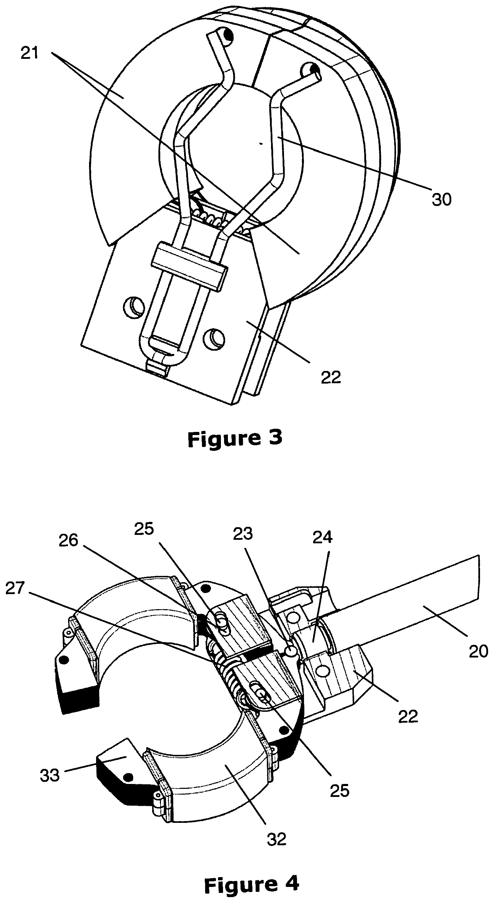

À titre d'exemple visible en détails sur la figure 4, les mâchoires 21 sont chacune montées à pivotement sur une armature 22 pouvant être reliée à la tige de commande 20 dont le mouvement de translation par rapport à l'armature 22 commande le mouvement de pivotement de chacune des mâchoires 21 par rapport à l'armature 22. L'axe de pivotement 23 des mâchoires 21 sur l'armature 22 est commun pour les deux mâchoires 21. Pour une commande précise du mouvement angulaire des mâchoires 21, la tête 24 de la tige de commande 20 est par exemple montée sur l'armature 22 par une liaison hélicoïdale transformant un mouvement de rotation par vissage imposé par l'utilisateur à la tige de commande 20 sur son extrémité opposée à la tête 24 en un mouvement de translation de la tête 24. À titre d'exemple le vissage et le dévissage de la tige 20 commandent un mouvement des mâchoires 21 respectivement vers leurs positions écartée et rapprochée. Dans son mouvement de translation, la tête 24 déplace avec elle dans un mouvement identique l'axe de pivotement 23. Pour transformer le mouvement de translation rectiligne de l'axe de pivotement 23 en un mouvement de pivotement des mâchoires 21, celles-ci sont équipées chacune d'un pion 25 monté coulissant dans une lumière 26 associée ménagée dans l'armature 22. Les deux lumières 26 s'étendent sensiblement perpendiculairement par rapport à la direction de translation de l'axe de pivotement 23. Les pions 25 sont reliés entre eux par un ressort 27 tendant à les rapprocher.

Un montage possible du tore 19 sur les mâchoires 21 consiste à monter le tore 19 sur un support 28 pouvant être rendu solidaire des mâchoires 21. Le support 28 est par exemple constitué par une goulotte souple assujettie aux mâchoires 21 par des moyens de fixation lui permettant de se conformer selon une forme correspondant à celle attendue du tore 19 qu'elle renferme. De tels moyens de fixation peuvent consister en un encliquetage rapide 35 (par exemple par un emboîtement de type mâle/femelle) prévu sur chacune des extrémités libres de la goulotte pour se solidariser à une mâchoire 21 correspondante. En complément, il est possible de maintenir la goulotte sensiblement au milieu de sa longueur sur l'armature au niveau d'une glissière 29.

Comme le montre la figure 3, un ressort de rappel 27 sollicite les mâchoires 21 vers leur position rapprochée pour assurer une fermeture au moins partiellement automatique du tore 19 vers sa position fermée, en complément de toute action portée par l'utilisateur sur la tige de commande 20. La figure 3 montre aussi un ressort 30 de centrage comprenant des tiges flexibles. Le ressort 30 est réalisé sous forme de pince ou de lyre permettant de tenir en position le capteur sur le câble et de le centrer au centre du tore et/ou du circuit magnétique. La forme de ce ressort 30 permet une adaptation automatiquement sur des diamètres de câbles différents, par exemple entre de 15 et 29 mm.

Dans la variante non limitative représentée sur la figure 7, chacune des mâchoires 21 est équipée d'un élément écarteur 31 par exemple en forme d'oreille agencée dans le prolongement du corps de la mâchoire 21. Les éléments écarteurs 31 sont agencés de sorte à transformer un effort appliqué par le câble 14 sur lesdits éléments écarteurs 31, en direction de l'intérieur du tore 19 lors de l'engagement du câble 14, en un mouvement d'écartement des mâchoires 21. Par exemple, les éléments écarteurs 31 comportent chacun une rampe inclinée par rapport à la direction attendue du mouvement d'engagement du câble 14 vers l'intérieur du tore 19.

Dans le mode de réalisation de la figure 2, à la différence de celui de la figure 1, le dispositif de mesure 12 du capteur comprend un circuit magnétique se refermant autour du câble 14 lorsque les moyens d'actionnement commandent la position fermée du tore 19, ainsi qu'un bobinage autour du circuit magnétique, pour alimenter l'électronique de mesure et/ou de transmission du résultat des mesures qui équipe le capteur. À cet effet, au moins l'une des mâchoires 21 peut porter, en référence à la figure 2, au moins une partie du circuit magnétique et du bobinage 32. Le circuit magnétique peut être réalisé par un assemblage par empilement de tôles 33. Par exemple, un empilement de tôles 33 peut constituer le corps de chacune des mâchoires 21 tandis que deux bobinages 32 peuvent être agencés pour chacun entourer l'un des empilements de tôles 33 sur au moins une partie de sa longueur. Dans la position rapprochée des mâchoires 21, les extrémités libres de celles-ci viennent en contact l'une de l'autre pour garantir la fermeture du circuit magnétique et, comme évoqué précédemment, pour garantir un entrefer constant. Le même résultat est obtenu au niveau de leurs extrémités articulées au niveau de l'axe de pivotement 23 grâce à la présence avantageuse du ressort 27. De plus, il est possible de prévoir que la section des tôles soit augmentée en s'approchant de leurs extrémités afin de réduire l'entrefer.

La figure 11 représente une position fermée des mâchoires constituées par des empilements de tôles 33 formant un circuit magnétique. Des extrémités 40 de chaque mâchoire ou partie du circuit magnétique sont maintenues serrées entre elles par le ressort 27.

En référence à la figure 8, chacun des bobinages 32 peut être formé sur une structure 34 par exemple en forme de manchon cintré pourvue d'encoches de maintien 36 du fil de bobinage 32 agencées pour permettre un bobinage sur une machine linéaire, s'affranchissant dans ce cas, mais de manière non limitative, de la nécessité d'un bobinage torique.

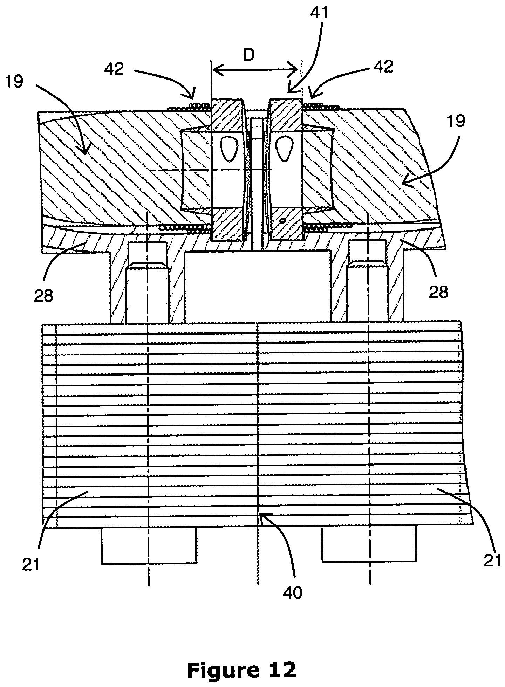

La figure 12 montre une vue détaillée de la zone d'ouverture du capteur dans sa position fermée. Lorsque le tore est en position fermée il a une zone non enroulée 41 de distance prédéterminée (D) et un surenroulement 42 à chaque extrémité d'ouverture dudit tore (19).

Il est possible de considérer que la tige de commande 20 appartienne aux moyens d'actionnement précédemment définis qui équipent le capteur 10 au niveau de chacun de ses dispositifs de mesure 12 dans le cas où la tige de commande 20 est solidaire en permanence de l'armature. Toutefois la tige de commande 20 peut ne pas appartenir directement au capteur 10 en tant que tel lorsqu'un montage amovible est prévu entre l'armature 22 du capteur 10 et la tige de commande 20. Dans ce dernier cas, par une action manuelle déportée par rapport au capteur 10, la tige de commande 20 permet à l'utilisateur du capteur 10 de contrôler à distance les moyens d'actionnement qui équipent le capteur au niveau de chacun de ses dispositifs de mesure 12.

L'invention n'est pas limitée à la cinématique des moyens d'actionnement qui vient d'être détaillée à titre exclusivement illustratif, et l'Homme du Métier pourra envisager toute solution équivalente et adaptée pour parvenir au résultat recherché, par exemple mettant en oeuvre une transmission utilisant des biellettes.

Enfin, un système d'éclairage peut éventuellement être monté dans l'axe de la tige de commande 20 pour permettre d'éclairer le câble 14 au moment du montage et du démontage des dispositifs de mesure 12 du capteur 10 sur les câbles 14. L'épaisseur de l'ensemble formé par le tore 19 et les mâchoires 21 peut être avantageusement inférieure à 30 mm afin de faciliter la manipulation du dispositif de mesure 12 entre les câbles 14. En effet, cette caractéristique permet d'insérer facilement les dispositifs de mesure 12 parmi les câbles 14 en les pivotant de 90 degrés (de sorte à les placer parallèlement aux câbles) par rapport à la configuration de mesure.

Dans le premier mode de réalisation dépourvu de circuit magnétique et de bobinage 32 d'alimentation de l'électronique du capteur, les empilements de tôles 33 et les bobinages 32 peuvent être remplacés par deux pièces monobloc, par exemple formées dans une matière plastique.

Il sera compris de ce qui précède que les dispositifs de mesure et de manière générale le capteur de mesure qui viennent d'être décrits peuvent être installés sur une installation sans nécessiter d'interruption de la distribution d'énergie électrique et sans mettre l'utilisateur dans une situation à risque. Ils présentent l'avantage supplémentaire d'un montage aisé sur les câbles de l'installation notamment lorsque de nombreux câbles rigides sont disposés proches les uns des autres. Enfin ils permettent une mesure de précision du courant électrique circulant dans au moins un câble tout en pouvant assurer simultanément, dans le deuxième mode de réalisation, une alimentation électrique d'une électronique du capteur.

Enfin, dans le cas où des données complémentaires peuvent être transmises depuis l'extérieur à l'électronique du capteur 10 telles que par exemple la tension de phase, il est possible de parvenir à un calcul de la puissance et de l'énergie circulant dans le câble 14. Ainsi un dispositif de mesure de puissance et d'énergie peut être obtenu à partir de l'utilisation d'au moins un capteur de mesure tel que décrit précédemment.

## Revendications

1. Dispositif de mesure (12) d'un courant électrique circulant dans un câble (14) comprenant
- un tore de Rogowski (19) souple
- des moyens de maintien dudit tore de Rogowski (19) souple pouvant occuper une position ouverte permettant l'engagement autour du câble et une position fermée apte à entourer le câble,
- des moyens d'actionnement susceptibles de passer ledit tore d'une position à l'autre, lesdits moyens d'actionnement comprenant deux mâchoires (21) articulées auxquelles le tore est solidarisé et pouvant occuper une position écartée et une position rapprochée plaçant le tore respectivement dans ses positions ouverte et fermée,
dispositif caractérisé ce qu'il comporte un support (28) solidaire des mâchoires et en ce que le tore est monté sur ledit support (28) solidaire des mâchoires, ledit support étant constitué par une goulotte souple assujettie aux mâchoires.

2. Dispositif selon selon la revendication 1, **caractérisé en ce qu'**il comporte un ressort de rappel (27) pour solliciter les mâchoires vers leur position rapprochée pour assurer une fermeture au moins partiellement automatique du tore.

3. Dispositif selon l'une des revendications 1 ou 2, **caractérisé en ce que** les mâchoires sont équipées d'éléments écarteurs (31) configurés de sorte à transformer un effort appliqué par le câble sur lesdits éléments écarteurs, en direction de l'intérieur du tore lors de l'engagement du câble, en un mouvement d'écartement des mâchoires.

4. Dispositif selon la revendication 3, **caractérisé en ce que** les éléments écarteurs comportent chacun une rampe inclinée par rapport à la direction attendue du mouvement d'engagement du câble vers l'intérieur du tore.

5. Dispositif selon l'une des revendications 1 à 4, **caractérisé en ce qu'**il comprend un circuit magnétique (33) se refermant autour du câble lorsque les moyens d'actionnement commandent la position fermée du tore, et un bobinage (32) autour du circuit magnétique, pour alimenter une électronique de mesure et/ou de transmission du résultat des mesures.

6. Dispositif selon les revendications 1 et 5, **caractérisé en ce qu'**au moins l'une des mâchoires porte au moins une partie du circuit magnétique et du bobinage, ledit circuit magnétique étant fermé lorsque les moyens de maintien sont en position fermée.

7. Dispositif selon l'une des revendications 5 et 6, **caractérisé en ce qu'**il comprend des moyens de centrage (30) pour centrer les moyens de maintien et les ledit tore autour d'un câble électrique, lesdits moyens de centrage étant sous forme tiges flexibles.

8. Dispositif selon l'une des revendications 5 à 7, **caractérisé en ce que** le bobinage est formé sur une structure permettant un bobinage linéaire.

9. Dispositif selon l'une des revendications 1 à 8, **caractérisé en ce que** les mâchoires sont chacune montées à pivotement sur une armature (22) pouvant être reliée à une tige de commande (20) dont le mouvement de translation par rapport à l'armature commande le mouvement de pivotement de chacune des mâchoires par rapport à l'armature.

10. Dispositif selon l'une des revendications 1 à 9, **caractérisé en ce que** lorsque le tore est en position fermée il a une zone (41) non enroulée de distance prédéterminée (D) et un surenroulement (42) à chaque extrémité d'ouverture dudit tore (19).

11. Ensemble de mesure (10) **caractérisé en ce qu'**il comprend au moins un dispositif de mesure (12) selon l'une des revendications précédentes.

12. Ensemble selon la revendication 11, **caractérisé en ce qu'**il comporte une électronique de mesure et/ou de transmission du résultat des mesures recevant des données du tore (19) du dispositif de mesure.

## Patentansprüche

1. Vorrichtung zum Messen (12) von einem elektrischen Strom, der in einem Kabel (14) fließt, umfassend
- eine flexible Rogowskispule (19)
- Mittel zum Halten der flexiblen Rogowskispule (19), die eine offene Position, die das Eingreifen um das Kabel herum ermöglicht, und eine geschlossene Position, die geeignet ist, das Kabel zu umgeben, einnehmen können,
- Betätigungsmittel, die geeignet sind, die Spule von einer Position zur anderen übergehen zu lassen, wobei die Betätigungsmittel zwei gelenkig verbundene Backen (21) aufweisen, mit denen die Spule fest verbunden ist und die eine beabstandete Position und eine angenäherte Position einnehmen können, wodurch die Spule jeweils in ihre offene und geschlossene Position platziert wird,
Vorrichtung, **dadurch gekennzeichnet, dass** sie eine Fassung (28) aufweist, die mit den Backen fest verbunden ist, und dadurch, dass die Spule auf der Fassung (28), die mit den Backen fest verbunden ist, angebracht ist, wobei die Fassung durch einen flexible Stutzen gebildet ist, der an den Backen befestigt ist.

2. Vorrichtung nach Anspruch 1, **dadurch gekennzeichnet, dass** sie eine Rückstellfeder (27) aufweist, um die Backen in Richtung ihrer angenäherten Position zu spannen, um ein mindestens teilweise automatisches Schließen der Spule zu gewährleisten.

3. Vorrichtung nach einem der Ansprüche 1 oder 2, **dadurch gekennzeichnet, dass** die Backen mit Abstandshalterelementen (31) ausgestattet sind, die konfiguriert sind, um eine Kraft, die durch das Kabel in Richtung des Inneren der Spule bei dem Eingreifen des Kabels auf die Abstandshalterelemente ausgeübt wird, in eine Bewegung des Spreizens der Klemmen umzuwandeln.

4. Vorrichtung nach Anspruch 3, **dadurch gekennzeichnet, dass** die Abstandshalterelemente jeweils eine Rampe aufweisen, die in Bezug auf die erwartete Richtung der Bewegung des Eingreifens des Kabels in Richtung des Inneren der Spule geneigt sind.

5. Vorrichtung nach einem der Ansprüche 1 bis 4, **dadurch gekennzeichnet, dass** sie einen Magnetkreis (33), der sich um das Kabel schließt, wenn die Betätigungsmittel die geschlossene Position der Spule steuern, und eine Wicklung (32) um den Magnetkreis aufweist, um eine Messelektronik und/oder eine Elektronik zum Übertragen des Ergebnisses der Messungen zu speisen.

6. Vorrichtung nach einem der Ansprüche 1 und 5, **dadurch gekennzeichnet, dass** mindestens eine der Backen mindestens einen Teil des Magnetkreises und der Wicklung trägt, wobei der Magnetkreis geschlossen ist, wenn sich die Haltemittel in geschlossener Position befinden.

7. Vorrichtung nach einem der Ansprüche 5 und 6, **dadurch gekennzeichnet, dass** sie Zentriermittel (30) aufweist, um die Haltemittel und die Spule um ein elektrisches Kabel herum zu zentrieren, wobei die Zentriermittel in Form von flexiblen Stangen sind.

8. Vorrichtung nach einem der Ansprüche 5 bis 7, **dadurch gekennzeichnet, dass** die Wicklung auf einer Struktur gebildet ist, die eine lineare Wicklung ermöglicht.

9. Vorrichtung nach einem der Ansprüche 1 bis 8, **dadurch gekennzeichnet, dass** die Backen jeweils schwenkbar an einer Armierung (22) angebracht sind, die mit einer Steuerstange (20) verbunden werden kann, deren Translationsbewegung in Bezug auf die Armierung die Schwenkbewegung jeder der Backen relativ zu der Armierung steuert.

10. Vorrichtung nach einem der Ansprüche 1 bis 9, **dadurch gekennzeichnet, dass** es, wenn die Spule in geschlossener Position ist, einen nicht aufgewickelten Bereich (41) von vorbestimmten Abstand (D) und eine Überwicklung (42) an jedem Ende der Öffnung der Spule (19) gibt.

11. Messanordnung (10), **dadurch gekennzeichnet, dass** sie mindestens eine Messvorrichtung (12) nach einem der vorhergehenden Ansprüche aufweist.

12. Anordnung nach Anspruch 11, **dadurch gekennzeichnet, dass** sie eine Messelektronik und/oder eine Elektronik zum Übertragen des Ergebnisses der Messungen aufweist, die Daten von der Spule (19) der Messvorrichtung empfängt.

## Claims

1. Device (12) for measuring an electric current flowing through a cable (14) comprising:
- a flexible Rogowski coil (19);
- means for holding said flexible Rogowski coil (19) that can occupy an open position allowing engagement around the cable and a closed position capable of surrounding the cable;
- actuation means suitable for moving said coil from one position to the other, said actuation means comprising two articulated jaws (21) to which the coil is rigidly connected and which can occupy an "apart" position and a "together" position placing the coil in its open and closed positions, respectively,
which device is **characterized in that** it includes a support (28) that is rigidly connected to the jaws and **in that** the coil is mounted on said support (28) that is rigidly connected to the jaws, said support consisting of a flexible conduit secured to the jaws.

2. Device according to Claim 1, characterized that it includes a return spring (27) for returning the jaws to their "together" position so that the coil closes at least partially automatically.

3. Device according to either of Claims 1 and 2, **characterized in that** the jaws are provided with spreading elements (31) that are configured to transform a force applied by the cable to said spreading elements, in the direction of the interior of the coil when engaging the cable, into a movement of spreading the jaws.

4. Device according to Claim 3, **characterized in that** the spreading elements each include a ramp that is inclined with respect to the expected direction of the movement for engaging the cable towards the interior of the coil.

5. Device according to one of Claims 1 to 4, **characterized in that** it comprises a magnetic circuit (33) that closes up around the cable when the actuation means place the coil in the closed position, and a winding (32) around the magnetic circuit, for supplying power to measurement electronics and/or electronics for transmitting the result of the measurements.

6. Device according to Claims 1 and 5, **characterized in that** at least one of the jaws bears at least a portion of the magnetic circuit and of the winding, said magnetic circuit being closed when the holding means are in the closed position.

7. Device according to one of Claims 5 and 6, **characterized in that** it comprises centring means (30) for centring the holding means and said coil around an electrical cable, said centring means taking the form of flexible rods.

8. Device according to one of Claims 5 to 7, **characterized in that** the winding is formed on a structure allowing a linear winding.

9. Device according to one of Claims 1 to 8, **characterized in that** the jaws are each pivotably mounted on an armature (22) that can be linked to a control rod (20), the translational movement of which with respect to the armature controls the pivoting movement of each of the jaws with respect to the armature.

10. Device according to one of Claims 1 to 9, **characterized in that** when the coil is in the closed position, it has an unwound area (41) of predetermined distance (D) and an overwinding (42) at each open end of said coil (19).

11. Measurement assembly (10) **characterized in that** it comprises at least one measurement device (12) according to one of the preceding claims.

12. Assembly according to Claim 11, **characterized in that** it includes measurement electronics and/or electronics for transmitting the result of the measurements receiving data from the coil (19) of the measurement device.
